(19) **Europäisches Patentamt**
European Patent Office
Office européen des brevets

(11) **EP 1 032 997 B1**

(12) **EUROPÄISCHE PATENTSCHRIFT**

(45) Veröffentlichungstag und Bekanntmachung des Hinweises auf die Patenterteilung:
**31.01.2007 Patentblatt 2007/05**

(51) Int Cl.:
*H04H 1/00* (2006.01)   *H04B 1/26* (2006.01)
*H03J 1/00* (2006.01)

(21) Anmeldenummer: **98961062.1**

(22) Anmeldetag: **02.11.1998**

(86) Internationale Anmeldenummer:
**PCT/DE1998/003192**

(87) Internationale Veröffentlichungsnummer:
**WO 1999/027667 (03.06.1999 Gazette 1999/22)**

(54) **RUNDFUNKEMPFÄNGER MIT ZWEI TUNER UND EINEM SCHALTER ZUR ÜBERPRÜFUNG DER EMPFANGQUALITÄT AUF EINER ALTERNATIVFREQUENZ**

RADIO RECEIVER WITH TWO TUNERS AND A SWITCH FOR VERIFYING RECEPTION QUALITY AT AN ALTERNATIVE FREQUENCY

RECEPTEUR RADIO COMPORTANT DEUX SYNTONISEURS ET UN INTERRUPTEUR POUR VERIFIER LA QUALITE DE RECEPTION A UNE FREQUENCE ALTERNATIVE

(84) Benannte Vertragsstaaten:
**DE FR GB IT**

(30) Priorität: **19.11.1997 DE 19751189**

(43) Veröffentlichungstag der Anmeldung:
**06.09.2000 Patentblatt 2000/36**

(73) Patentinhaber: **ROBERT BOSCH GMBH**
**70442 Stuttgart (DE)**

(72) Erfinder:
• **VOGT, Lothar**
**D-31199 Barienrode (DE)**
• **BLACK, Karl-Heinz**
**D-31139 Hildesheim (DE)**

(56) Entgegenhaltungen:
EP-A- 0 333 194     DE-A- 4 104 882
US-A- 5 345 602     US-A- 5 430 890

**Beschreibung**

Die Erfindung betrifft einen Rundfunkempfänger mit einer Schaltungsanordnung zur Überprüfung der Empfangsqualität auf einer Alternativfrequenz zu einer empfangenen Sendefrequenz mit zwei Tunern zum Umsetzen der empfangenen Signale in zwei verschiedene Zwischenfrequenzen, einem Schalter zur wahlweisen Weiterleitung von Signalen aus jeweils einen der Tuner enthaltenden Signalverarbeitungszweigen an einen Demodulator und mit einer Prüfeinrichtung für die Bestimmung der Signalqualität.

Moderne Rundfunkempfänger, insbesondere solche, die an wechselnden Einsatzorten verwendet werden, wie vorzugsweise Autoradios, sind mit einer Schaltungsanordnung zur Überprüfung der Empfangsqualität eines eingestellten Senders auf einer Alternativfrequenz dieses Senders ausgestattet. Die Information über Alternativfrequenzen ergeben sich im Allgemeinen aus kodierten Informationen, die mit einer ausgestrahlten Sendung übermittelt werden, beispielsweise in RDS-Signalen (Radio-Daten-System). Die Überprüfung der Empfangsqualität auf einer oder mehrerer Alternativfrequenzen erfolgt dabei entweder regelmäßig oder beim Abfall der Empfangsqualität des gewählten Senders auf der eingestellten Frequenz.

Es ist bekannt, den Rundfunkempfänger zu diesem Zweck mit zwei separaten Empfängern auszustatten, wobei einer der Empfänger stets im Hintergrund Alternativfrequenzen auswählt und überprüft. Aus Gründen der Entkoppelung zur Vermeidung von gegenseitigen Störeinflüssen sind die Zwischenfrequenzen der beiden Empfänger unterschiedlich. Ein Mikroprozessor vergleicht jeweils die Qualität des durch den Hintergrundempfänger auf der Alternativfrequenz empfangenen Senders mit dem eingestellten Programm. Diese Hintergrundüberprüfung erfolgt für den Benutzer des Rundfunkempfängers ohne merkbare Unterbrechungen des Empfangs. Allerdings ist für dieses Konzept ein relativ hoher Aufwand erforderlich, da die beiden Empfänger komplett mit Tunern, ZF-Filtern, und ZF-Stufen mit Demodulator, RDS-Decoder, Signalqualitätsprüfeinrichtung usw. ausgestattet sind. Ein ähnliches Konzept ist in US 5,345,602 bzw. EP 0 531 725 A2 beschrieben. Dabei sind zwei separate Empfänger vorgesehen, die jeweils eine eigene Antenne, eine eigene Mischstufe für die Umsetzung in eine Zwischenfrequenz und eine eigene Zwischenfrequenzstufe aufweisen. Die beiden Empfänger können auf dasselbe Signal abgestimmt sein.

Einer der Empfänger kann kurzfristig derart umgeschaltet werden, dass der Empfang einer Alternativfrequenz zu der empfangenen Sendefrequenz erfolgt. Von einem Mikroprozessor als Prüfeinrichtung wird die Qualität des empfangenen Signals auf der Alternativfrequenz feststellt und einem Umschaltung veranlasst, wenn die von dem anderen Empfänger, der mit einem Niederfrequenzverstärker und einem Lautsprecher verbunden ist, empfangene Signalstärke einen Grenzwert unterschreitet.

Es ist ferner bekannt, die Prüfung der Alternativfrequenzen mit nur einem einzigen Empfänger durchzuführen. Hierfür wechselt die PLL (Phase-Locked-Loop) des Tuners kurzzeitig auf eine Alternativfrequenz. Der Empfang auf der Alternativfrequenz wird geprüft und die Entscheidung herbeigeführt, ob die Alternativfrequenz einen besseren Empfang erlaubt als die aktuell eingestellte Frequenz oder nicht. Ist der Empfang auf der Alternativfrequenz schlechter, wird auf die ursprüngliche Frequenz zurückgewechselt und ggf. die Prüfung für eine weitere Alternativfrequenz durchgeführt. Dieses Konzept ist kostengünstiger, weist jedoch den Nachteil auf, dass das gehörte Programm durch die Prüfpausen kurzfristig, jedoch merkbar, gestört wird.

Aus dem Stand der Technik ergibt sich somit das Problem, dass entweder ein hoher Kostenaufwand erforderlich ist, um die Prüfung der Alternativfrequenzen durchzuführen, oder bei einem geringeren Kostenaufwand eine merkbare Beeinträchtigung des gehörten Programms in Kauf genommen werden muss.

Die der Erfindung zugrundeliegende Problemstellung besteht somit darin, einerseits den hohen Kostenaufwand für zwei komplette separate Empfänger zu vermeiden und andererseits die Störung des gehörten Programms zumindest zu verringern.

Erfindungsgemäß wird das genannte Problem mit einem Rundfunkempfänger mit den Merkmalen des Patentanspruchs 1 gelöst.

Erfindungsgemäß werden wie beim Konzept mit zwei Empfängern zwei Tuner verwendet, die das empfangene Signal in unterschiedliche Zwischenfrequenzen umsetzen. Allerdings ist für beide Tuner eine gemeinsame Zwischenfrequenzstufe mit einem Zwischenfrequenzfilter, einem Demodulator, einem Decoder für Zusatzsignale und eine Prüfeinrichtung für die Signalqualität vorgesehen, sodass über den beispielsweise als Multiplexer ausgeführten Schalter entweder die Zwischenfrequenz des einen Tuners oder die Zwischenfrequenz des anderen Tuners auf die Zwischenfrequenzstufe leitbar ist. Dies ist möglich, weil der Analog-Digital-Wandler, der mit einer Abtastfrequenz ($f_a$) betrieben wird, die unterschiedlichen Zwischenfrequenzen digitalisieren kann, wenn beide Zwischenfrequenzen die Bedingung

$$f_0 = (n+R)\, f_a$$

erfüllen, was grundsätzlich durch DE 41 04 882 AI bekannt ist. Somit können beide Zwischenfrequenzen ohne Zusatzmaßnahmen erfindungsgemäß von derselben Zwischenfrequenzstufe verarbeitet werden.

Demgemäß findet die Überprüfung von Alternativfrequenzen dadurch statt, dass die Verarbeitung der durch den eingestellten Tuner empfangenen Signale durch den vorzugsweise von einem Mikroprozessor gesteuerten Schalter unterbrochen wird, um die Prüfung der Alternativfrequenz vorzunehmen. Im Unterschied zum Konzept mit einem Empfänger braucht die Unterbrechung nur für den kurzen Prüfzeitraum zu erfolgen, während bei der Umschaltung eines einzigen Tuners die zugehörigen PLL auf die neue Mischfrequenz einschwingen muss, sodass beim Schalten auf eine Alternativfrequenz und Zurückschalten auf die ursprüngliche Frequenz zwei jeweils im Millisekundenbereich liegende Einschwingvorgänge zur Prüfzeit hinzukommen und die Gesamt-Unterbrechungsdauer bilden. Die erfindungsgemäß entstehende Unterbrechung ist daher mindestens um den Faktor 2 kurzer, sodass die Unterbrechung des gehörten Programms kaum noch merkbar ist. Findet eine Überprüfung einer Alternativfrequenz statt, von der durch eine frühere Überprüfung bekannt ist, dass sie brauchbar empfangbar ist, wird das empfangene Programm überhaupt nicht merkbar unterbrochen.

Besteht jedoch das Risiko, dass der Empfang auf der Ahemativfrequenz sehr schlecht ist, sodass ein stark verrauschtes Signal empfangen werden könnte, ist es zweckmäßig, für den kurzen Prüfzeitraum den Niederfrequenzkanal stumm zu schalten, um keine störenden Rauschsignale zum Lautsprecher durchzulassen.

Da die Unterbrechung bei der erfindungsgemäßen Prüfung aufgrund ihrer Kürze eine kaum merkbare Beeinträchtigung des gehörten Programms hervorruft, kann es erfindungsgemäß zweckmäßig sein, durch Überprüfung einer Vielzahl von Frequenzen eine anzeigbare Tabelle für am Empfangsort empfangbare Frequenzen bzw. Sender zu erstellen und abzuspeichern, sodass eine gezielte Anwahl von geeigneten Sendern bzw. Sendefrequenzen möglich ist

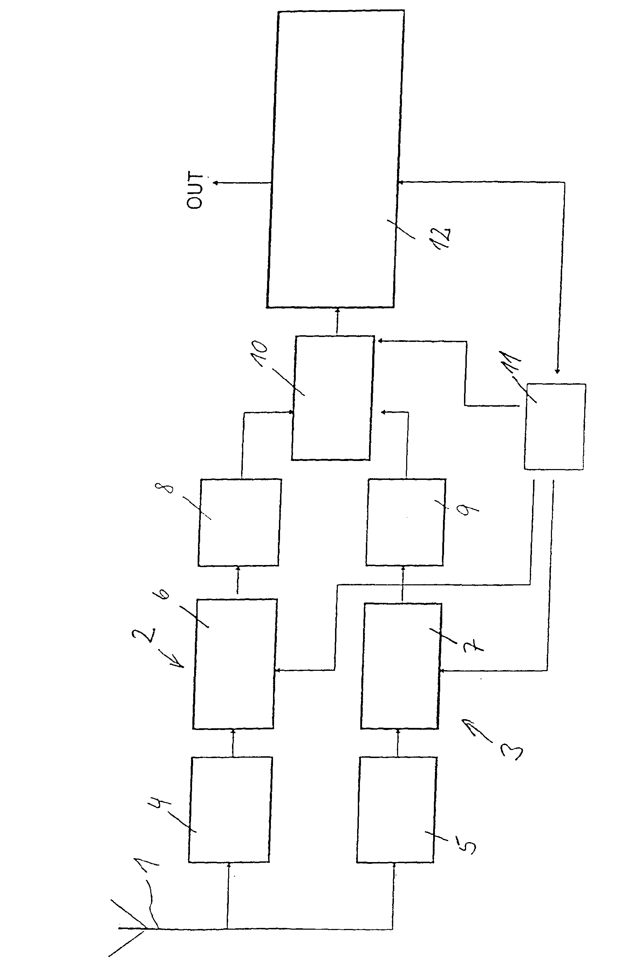

Ein Ausführungsbeispiel der Erfindung ist schematisch in Form eines Blockschaltbildes in der Zeichnung dargestellt. An eine Empfangsantenne 1 sind zwei parallele Tunerzweige 2, 3 angeschlossen, die jeweils aus einer das Empfangssignal im wesentlichen verstärkenden Vorstufe 4, 5, einem sich anschließenden Tuner 6, 7 und einem nachgeschalteten Filter 8, 9 bestehen. Die Filter 8, 9 sind dabei keine üblichen Zwischenfrequenzfilter, die der Senderselektion in dem vom Tuner 6, 7 umgesetzten Empfangsband dienen, sondern haben lediglich eine Bandbegrenzungsfunktion, um modulationsbedingte Spiegelfrequenzen o.ä. abzuschneiden. Die Ausgänge der beiden Filter 8, 9 sind mit zwei Eingängen eines Schalters 10 in Form eines Multiplexers verbunden, dessen Schaltzustand durch einen Mikroprozessor 11 gesteuert wird. Der Multiplexer 10 ist im Normalfall so geschaltet, daß das Ausgangssignal des ersten Tunerzweigs 2 durch den Multiplexer 10 durchgeschaltet wird und so auf eine Zwischenfrequenzstufe 12 gelangt, die als hoch integrierter Schaltkreis einen Analog-Digital-Wandler für die Zwischenfrequenz, ein die Selektion bewirkendes Zwischenfrequenzfilter, einen digitalen Demodulator, einen RDS-Decoder und eine Prüfeinrichtung für die Sig-nalqualität beinhaltet. Die Prüfung der Signalqualität erfolgt in an sich bekannter Weise durch Überprüfung der Feldstärke, von Nachbarkanalstörungen, eines Mehrwegeempfangs, einer RDS-Bitfehlerrate usw.

Ein Abfall der über den ersten Tunerzweig 2 empfangenen Signalqualität wird vom Mikroprozessor 11 ausgewertet und führt dazu, daß der Mikroprozessor 11 den Multiplexer 10 umschaltet, so daß nunmehr ein vom durch den Mikroprozessor 11 vorher auf eine Alternativfrequenz eingestellten Tuner 7 empfangenes Signal auf der Zwischenfrequenz des zweiten Tunerzweigs 3 über den Multiplexer 10 auf die Zwischenfrequenzstufe 12 gelangt.

Der Analog-Digital-Wandler der Zwischenfrequenzstufe 12 arbeitet beispielsweise mit einer Abtastfrequenz von 14,25 MHz und ist daher geeignet, ein Zwischenfrequenzsignal auf der Frequenz 10,6875 MHz am Ausgang des ersten Tunerzweigs 2 wie auch eine Zwischenfrequenz von 67,6875 MHz am Ausgang des zweiten Tunerzweigs 3 zu digitalisieren, da für diese beiden Zwischenfrequenzen die Beziehung

$$f_0 = (n+R)\ f_a$$

erfüllt ist, wobei für den ersten Tunerzweig 2 n=0 und R=0,75 und für den zweiten Tunerzweig 3 n=4 und R=0,75 gilt.

Die Empfangsqualität auf der Alternativfrequenz wird durch die Zwischenfrequenzstufe 12 überprüft und durch den Mikroprozessor 11 dahingehend ausgewertet, daß bei einer besseren Empfangsqualität die Umschaltung des Multiplexers 10 erhalten bleibt, während bei einer schlechteren Empfangsqualität der Multiplexer 10 auf das Ausgangssignal des ersten Tunerzweigs 2 zurückschaltet. In diesem Fall kann sich die Prüfung einer weiteren Alternativfrequenz im zweiten Tunerzweig 3 anschliessen. Ferner kann vorgesehen sein, die Signalqualität von alternativen Senderfrequenzen in vorgegebenen Zeitabständen (beispielsweise alle 5 Minuten) zu überprüfen, um so eine ständige Empfangsoptimierung durchzuführen.

Der Mikroprozessor 11 erhält die Informationen über mögliche Alternativfrequenzen im allgemeinen aus dem in der Zwischenfrequenzstufe 12 dekodierten RDS-Signal, in dem regelmäßig Informationen über Alternativfrequenzen übermittelt werden. Es ist aber auch möglich, daß durch eine Abfrage von zahlreichen Frequenzen des Rundfunkfrequenzbandes vom Mikroprozessor 11 eine Tabelle der empfangbaren Frequenzen und der damit übermittelten Senderkennungen erstellt und abgespeichert wird, so daß sich mögliche Alternativfrequenzen auch aus dieser Tabelle ergeben können. In erster Linie hat die Tabelle jedoch die Funktion, dem Benutzer des Autoradios eine Bedienungshilfe zu geben, indem beispielsweise auf einem Display die am Empfangsort empfangbaren Sender angezeigt werden und ggfs. direkt anwählbar sind. Die Zeichnung verdeutlicht, daß beide Tuner 6, 7 durch den Mikroprozessor 11 auf gewünschte Empfangsfrequenzen einstellbar sind.

Da die Einstellung der in den beiden Tunern 6, 7 enthaltenen PLLs durch den Mikroprozessor 11 vor der Umschaltung des Multiplexers 10 erfolgen kann, führen Einschwingvorgänge der PLL des Tuners 6, 7, der durch den Multiplexer 10 gerade nicht zur Zwischenfrequenzstufe 12 durchgeschaltet ist, nicht zu einer Beeinträchtigung des gehörten Signals.

Der Aufwand für die erfindungsgemäße Schaltungsanordnung besteht gegenüber dem Konzept mit einem Empfänger in der Bereitstellung einer zweiten Vorstufe, eines zweiten Tuners und eines Bandbegrenzungsfilters und ist daher vergleichsweise gering, da der wesentlich größere Aufwand in der Zwischenfrequenzstufe 12 nicht verdoppelt wird. Durch den relativ geringen Zusatzaufwand läßt sich jedoch eine erhebliche Verringerung der Störung des Rundfunkempfangs durch die Prüfung von Alternativfrequenzen erreichen. Durch die Verwendung zweier verschiedener Zwischenfrequenzen werden Störungen durch Verkopplungen und Übersprechen vermieden, die bei der Verwendung einer gemeinsamen Zwischenfrequenz auftreten würden.

## Patentansprüche

1. Rundfunkempfänger mit einer Schaltungsanordnung zur Überprüfung der Empfangsqualität auf einer Alternativfrequenz zu einer empfangenen Sendefrequenz mit zwei Tunern (6, 7) zum Umsetzen der empfangenen Signale in zwei verschiedene Zwischenfrequenzen, einem Schalter (10) zur wahlweisen Weiterleitung von Signalen aus jeweils einen der Tuner (6, 7) enthaltenden Signalverarbeitungszweigen (2, 3) an einen Demodulator und mit einer Prüfeinrichtung für die Bestimmung der Signalqualität, **dadurch gekennzeichnet, dass** der Schalter (10) vor einem mit einer Abtastfrequenz $f_a$ betriebenen Analog-Digital-Wandler einer Zwischenfrequenzstufe (12) des Rundfunkempfängers angeordnet ist, und dass die Zwischenfrequenzen $f_0$ so gewählt sind, dass sie beide die Bedingung

$$f_0 = (n + R)\, f_a$$

erfüllen, wobei n eine natürliche Zahl oder 0 und R ein für beide Zwischenfrequenzen gleicher Wert mit $0 \leq R \leq 1$ ist, und dass sich in der Zwischenfrequenzstufe (12) an den Analog-Digital-Wandler ein Zwischenfrequenzfilter, der Demodulator und die Prüfeinrichtung für die Bestimmung der Signalqualität anschließen.

2. Rundfunkempfänger nach Anspruch 1, **dadurch gekennzeichnet, dass** die Zwischenfrequenzstufe (12) zusätzlich einen Decoder für Zusatzsignale umfasst.

3. Rundfunkempfänger nach Anspruch 1 oder 2, **dadurch gekennzeichnet, dass** während einer Umschaltung des Schalters (10) auf eine Alternativfrequenz ein an die Zwischenfrequenzstufe (12) angeschlossener Niederfrequenzkanal stumm schaltbar ist.

4. Rundfunkempfänger nach Anspruch 3, **dadurch gekennzeichnet, dass** die Stummschaltung nicht wirksam geschaltet wird, wenn eine Empfangbarkeit der Alternativfrequenz bereits festgestellt worden ist.

5. Rundfunkempfänger nach einem der Ansprüche 1 bis 4, **dadurch gekennzeichnet, dass** durch Überprüfung einer Vielzahl von Frequenzen eine anzeigbare Tabelle für die am Empfangsort empfangbare Frequenzen bzw. Sender erstellbar und abspeicherbar ist.

6. Rundfunkempfänger nach einem der Ansprüche 1 bis 5, **dadurch gekennzeichnet, dass** die Umschaltung des Schalters (10) im Falle eines Abfalls der Signalqualität der empfangenen Sendefrequenz mittels der Prilfeinrichtung auslösbar ist_

7. Rundfunkempfänger nach einem der Ansprüche 1 bis 6, **dadurch gekennzeichnet, dass** eine Umschaltung des Schalters (10) auf den eine Alternativfrequenz empfangenden Tuner (6, 7) in festen zeitlichen Abständen auslösbar ist.

**Claims**

1. Broadcast radio receiver having a circuit arrangement for checking the reception quality on an alternative frequency to a received transmission frequency, having two tuners (6, 7) for converting the received signals into two different intermediate frequencies, a switch (10) for selectively forwarding signals from signal processing paths (2, 3) which respectively contain one of the tuners (6, 7) to a demodulator, and having a testing device for determining the signal quality, **characterized in that** the switch (10) is arranged upstream of an analogue/digital converter, operated at a sampling frequency $f_a$, in an intermediate-frequency stage (12) of the broadcast radio receiver, and **in that** the intermediate frequencies $f_0$ are chosen such that they both meet the condition

$$f_0 = (n + R) f_a,$$

where n is a natural number or 0 and R is a value which is the same for both intermediate frequencies, with $0 \le R \le 1$, and **in that** in the intermediate-frequency stage (12) the analogue/digital converter is adjoined by an intermediate-frequency filter, the demodulator and the testing device for determining the signal quality.

2. Broadcast radio receiver according to Claim 1, **characterized in that** the intermediate-frequency stage (12) additionally comprises a decoder for additional signals.

3. Broadcast radio receiver according to Claim 1 or 2, **characterized in that** while the switch (10) is changing over to an alternative frequency it is possible to mute an audio-frequency channel connected to the intermediate-frequency stage (12).

4. Broadcast radio receiver according to Claim 3, **characterized in that** the muting is not activated if it has already been established that it is possible to receive the alternative frequency.

5. Broadcast radio receiver according to one of Claims 1 to 4, **characterized in that** by checking a multiplicity of frequencies it is possible to create and store a displayable table for the frequencies or stations which can be received at the reception location.

6. Broadcast radio receiver according to one of Claims 1 to 5, **characterized in that** changeover of the switch (10) can be initiated by means of the testing device in the event of a drop in the signal quality of the received transmission frequency.

7. Broadcast radio receiver according to one of Claims 1 to 6, **characterized in that** changeover of the switch (10) to the tuner (6, 7) receiving an alternative frequency can be initiated at fixed intervals of time.

**Revendications**

1. Récepteur radio comprenant un circuit pour vérifier la qualité de réception à une fréquence alternative par rapport à une fréquence d'émission reçue, avec deux syntoniseurs (6, 7) pour convertir les signaux reçus en deux fréquences intermédiaires différentes, un commutateur (10) pour la transmission au choix vers un démodulateur de signaux de branches de traitement de signaux (2, 3) comprenant respectivement l'un des syntoniseurs (6, 7), et un dispositif de vérification pour déterminer la qualité des signaux,
**caractérisé en ce que**
le commutateur (10) est en amont d'un convertisseur analogique/numérique, fonctionnant à une fréquence d'échantillonnage $f_a$, d'un niveau de fréquence intermédiaire (12) du récepteur radio, et
les fréquences intermédiaires $f_0$ sont choisies de manière à remplir toutes les deux la condition

$$f_0 = (n + R) f_a$$

n étant un entier naturel ou 0 et R ou une valeur identique pour les deux fréquences intermédiaires avec $0 \le R \le 1$, et un filtre de fréquence intermédiaire, le démodulateur et le dispositif de vérification pour déterminer la qualité des signaux sont raccordés au convertisseur analogique/numérique situé au niveau de fréquence intermédiaire (12).

**2.** Récepteur radio selon la revendication 1,
**caractérisé en ce que**
le niveau de fréquence intermédiaire (12) comprend également un décodeur pour des signaux supplémentaires.

**3.** Récepteur radio selon la revendication 1 ou 2,
**caractérisé en ce que**
pendant une commutation du commutateur (10) sur une fréquence alternative, un canal à basse fréquence raccordé au niveau de fréquence intermédiaire (12) peut être réglé silencieux.

**4.** Récepteur radio selon la revendication 3,
**caractérisé en ce que**
le réglage silencieux n'est pas activé si une possibilité de réception de la fréquence alternative a déjà été constatée.

**5.** Récepteur radio selon l'une des revendications 1 à 4,
**caractérisé en ce qu'**
en vérifiant une multitude de fréquences, on peut créer et mémoriser un tableau affichable des fréquences ou émetteurs disponibles sur le lieu de réception.

**6.** Récepteur radio selon l'une des revendications 1 à 5,
**caractérisé en ce que**
la commutation du commutateur (10) peut être déclenchée au moyen du dispositif de vérification dans le cas d'une baisse de la qualité des signaux de la fréquence d'émission reçue.

**7.** Récepteur radio selon l'une des revendications 1 à 6,
**caractérisé en ce qu'**
une commutation du commutateur (10) sur le syntoniseur (6, 7) recevant une fréquence alternative peut être déclenchée à des intervalles de temps fixes.